# EUROPEAN PATENT APPLICATION

(11) **EP 0 854 200 A1**
(43) Date of publication of application: **22.07.1998**
(21) Application number: 97306812.5
(22) Date of filing: 03.09.1997
(51) Int. Cl.: C22C 9/00, C22F 1/08, H01L 23/495

(54) **Copper-beryllium alloy**

(30) Priority: 28.10.1996 US 739230
(71) Applicant: Brush Wellman Inc., Cleveland, Ohio 44110 (US)
(72) Inventor: Harkness, John Charles, Lakewood, Ohio 44107 (US); Wolf, Shelley Joan, Holland, Ohio 43528 (US)
(74) Representative: Harrison, Ivor Stanley

(57) **Abstract**

A higher order beryllium-nickel-copper alloy and a process for making the same, the alloy being represented by the formula (0.15-0.5% Be) + (1.25-2.0% Ni) + [(0.06-1% Zr) and/or (0.06-1% Ti)], the balance copper, where the sum of %Zr and %Ti is generally within a range of 0.06% and 1%, characterized by improved stress relaxation resistance without sacrificing strength or electrical conductivity. Also provided is a higher order beryllium-cobalt-copper alloy and process, the alloy being represented by the formula (0.15-0.5% Be) + (0.35-0.6% Co) + [(0.06-1% Zr) and/or (0.06-1% Ti)], the balance copper, where the sum of %Zr and %Ti is generally within a range of 0.06% and 1%, characterized by improved stress relaxation resistance without sacrificing strength or electrical conductivity.

## Description

The present invention relates generally to alloys and more particularly to lean alloys of beryllium-copper having high conductivity and relaxation resistance.

Beryllium-copper alloys are notable for their superior combination of high conductivity, formability, strength and resistance to corrosion. For these reasons, they are considered particularly suited to the construction of electronic connectors for automobiles and lead frames for semi-conductor chips.

In conventional beryllium-copper alloys, cobalt has been used as an additive to improve strength. In this connection, nickel has also been added, alternatively or concurrently with cobalt, with the added benefit of increasing the alloy's conductivity. In an attempt to lower cost, decreased beryllium content has been considered. However, the results have been concurrent loss of strength, stress relaxation resistance, and in some cases conductivity.

It is therefore an object of the present invention to provide a high performance beryllium-copper alloy with superior stress relaxation resistance without sacrificing formability, conductivity or strength.

Another object of the present invention is to provide a high performance alloy with superior electrical conductivity.

Yet another object of the present invention is to provide simple, efficient and economical production of novel high performance alloys using conventional methods.

A further object of the present invention is to provide a lean alloy of beryllium-copper with enhanced properties.

Yet a further object of the present invention is to improve performance of electrical connectors.

Still another object of the present invention is to enhance performance of semi-conductor lead frames.

According to one aspect of the present invention is a higher order beryllium-nickel-copper alloy represented by the formula (0.15-0.5% Be) + (1.25-2.0% Ni) + (0.06-1% Zr), the balance copper, characterized by improved stress relaxation resistance without sacrificing strength or electrical conductivity.

In accordance with another aspect of the present invention is a higher order beryllium-nickel-copper alloy represented by the formula (0.15-0.5% Be) + (1.25-2.0% Ni) + (0.06-1% Ti) , the balance copper, characterized by improved stress relaxation resistance without sacrificing strength or electrical conductivity.

In accordance with a further aspect of the present invention is a higher order beryllium-nickel-copper alloy represented by the formula (0.15-0.5% Be) + (1.25-2.0% Ni) + (0.06-1% Zr) + (0.06-1% Ti), the balance copper, where the sum of %Zr and %Ti is generally within a range of 0.06% and 1%, characterized by improved stress relaxation resistance without sacrificing strength or electrical conductivity.

In accordance with still another aspect of the present invention is a higher order beryllium-cobalt-copper alloy represented by the formula (0.15-0.5% Be) + (0.35-0.6% Co) + (0.06-1% Zr), the balance copper, characterized by improved stress relaxation resistance without sacrificing strength or electrical conductivity.

Still a further aspect of the present invention is a higher order beryllium-cobalt-copper alloy represented by the formula (0.15-0.5% Be) + (0.35-0.6% Co) + (0.06-1% Ti) , the balance copper, characterized by improved stress relaxation resistance without sacrificing strength or electrical conductivity.

In accordance with yet a further aspect of the present invention is a higher order beryllium-cobalt-copper alloy represented by the formula (0.15-0.5% Be) + (0.35-0.6% Co) + (0.06-1% Zr) + (0.06-1% Ti), the balance copper, where the sum of %Zr and %Ti is generally within a range of 0.06% and 1%, characterized by improved stress relaxation resistance without sacrificing strength or electrical conductivity.

In accordance with still another aspect of the present invention is a method of producing a lean beryllium-cobalt-copper alloy with zirconium and/or titanium additions represented by the formula (0.15-0.5% Be) + (0.35-0.6 Co) + [(0.06-1% Ti) and/or (0.06-1% Zr)], the balance copper, where the sum of %Zr and %Ti is generally within a range of 0.06% and 1%, the method comprising steps of:
(i) melting a composition represented by the formula,
(ii) casting the melt into billets,
(iii) hot rolling the billets into strip, (iv) cold rolling the strip to a selected ready-
to-finish thickness,
(v) final solution annealing the cold rolled strip at a temperature generally within a range of 1450°F and 1850°F followed by rapid quenching,
(vi) cold working the annealed strip generally within a range of 50% and 95% to final thickness and
(vii) final age hardening the cold worked strip at a temperature generally within a range of 700°F and 800°F for a time generally within a range of 1 and 5 hrs.

In accordance with still a further aspect of the present invention is a method of producing a lean beryllium-nickel-copper alloy with zirconium and/or titanium additions represented by the formula (0.15-0.5% Be) + (1.25-2.0% Ni) + [(0.06-1% Ti) and/or (0.06-1% Zr)], the balance copper, where the sum of %Zr and %Ti is generally within a range of 0.06% and 1%, the method comprising steps of:
(i) melting a composition represented by the formula,
(ii) casting the melt into billets,
(iii) hot rolling the billets into strip,
(iv) intermediate annealing the cold rolled strip at about 1650°F,
(v) cold rolling the strip to a selected ready-to-finish thickness,
(vi) final solution annealing the cold rolled strip at a temperature of about 1650°F followed by rapid quenching,
(vii) cold working the annealed strip generally within a range of 0% and 37% to final thickness, and
(viii) final age hardening the cold worked strip at a temperature of about 900°F for about 3 hrs.

Although the present invention is shown and described in connection with beryllium-copper alloys, it may be adapted for improving characteristics of other precipitation hardenable materials such as aluminum-based alloys and other copper or nickel-based alloys.

Still other objects and advantages of the present invention will become apparent from the following description of the preferred embodiments.

The present invention relates to the discovery of a unique combination of constituents which, when added to beryllium-copper alloys, not only reduces the proportion of beryllium necessary to maintain performance but also improves alloy properties.

Such has been found particularly desirable for use in lead frames and electronic connectors for high technology applications. Exemplary lead frames are shown, for example, in U.S. Patent Nos. 5,437,096 and 5,525, 836, which issued on August 1, 1995 and June 11, 1996, respectively, the disclosures of which are hereby incorporated by reference in their entirety. Sample electronic connectors are set forth in U.S. Patent No. 5,037,311, which issued on August 6, 1991 and in the "Connector Engineering Design Guide" - Material Selection in the Design of Spring Contacts and Interconnection, by Brush Wellman Inc. - Technical Staff, July, 1995, the disclosures of which are hereby incorporated by reference in their entirety.

To illustrate, circuit integrity in electronic connectors is often dependent upon maintenance of a minimum contact, normal force over the life of a mated connector. During operation of the connector at elevated temperatures, a phenomenon known as "stress relaxation" may occur. Stress relaxation, by one definition, is a thermally-activated loss of normal force at constant spring deflection over time at an elevated temperature. It has been found that connectors which require a specified minimum normal force for electrical continuity must necessarily be overdesigned with respect to the normal force at room temperature, in order to compensate for any expected time-dependent stress loss through relaxation at usual operating temperatures.

An undesirable side effect of "overdesigning" is an increase in insertion force. Alloys with a high stress relaxation resistance not only allow a lower insertion force to be used but also enable thinner strip and/or smaller spring beams to be used, thereby reducing cost. And this is done with sacrificing contact performance.

Stress relaxation is normally measured on tapered cantilever beam specimens, deflected in a fixture to impart an initial stress that is a predetermined fraction of the 0.2% offset yield strength at room temperature of the strip being tested. Stress relaxation is reported as the "% remaining" initial stress after exposure for various times (about a 1000 hrs. and, in some cases, up to about 10,000 hrs.) at a selected temperature.

Stress relaxation resistance typically falls within three categories among conductive spring alloys, depending on the strengthening mechanism at work in the alloy. The lowest grade relaxation resistance is found in copper alloys strengthened only by solid solution and cold work (e.g., C26000 brass and C51000 phosphor bronze). Next are precipitation (nucleation and growth) hardened copper alloys (e.g., C17200, C17510, C17500, C17410, and C7025) whose heat treated strength generation offer significantly higher stress relaxation resistance. Further increase in relaxation resistance has been found in copper alloys strengthened by spinodal decomposition (or spinodal alloys) in response to heat treatment (e.g., C72900 and 4 wt.% Ti-Cu).

The foregoing discussion is provided for purposes of illustration and is not intended to limit the intended environment. The remaining aspects of connectors and lead frames are known by those skilled in the art and further description is believed unnecessary for illustration of the present invention.

According to one aspect of the present invention is a higher order beryllium-nickel-copper alloy represented by the formula (0.15-0.5% Be) + (1.25-2.0% Ni) + (0.06-1% Zr), the balance copper. The alloy is advantageous in providing improved stress relaxation resistance without sacrificing strength or electrical conductivity.

In accordance with another aspect of the present invention is a higher order beryllium-nickel-copper alloy represented by the formula (0.15-0.5% Be) + (1.25-2.0% Ni) + (0.06-1% Ti), the balance copper. This alloy is also characterized by improved stress relaxation resistance without sacrificing strength or electrical conductivity.

According to a further aspect of the present invention is a higher order beryllium-nickel-copper alloy represented by the formula (0.15-0.5% Be) + (1.25-2.0% Ni) + [(0.06-1% Zr) and/or (0.06-1% Ti)], the balance copper. The sum of %Zr and %Ti is generally within a range of 0.06% and 1%. Again, improved stress relaxation resistance is provided without sacrifice in strength or electrical conductivity.

Turning now to alloy embodiments including cobalt, there is provided a higher order beryllium-cobalt-copper alloy represented by the formula (0.15-0.5% Be) + (0.35-0.6% Co) + (0.06-1% Zr), the balance copper, characterized by improved stress relaxation resistance without sacrificing strength or electrical conductivity. Alternatively, a higher order beryllium-cobalt-copper alloy is provided, represented by the formula (0.15-0.5% Be) + (0.35-0.6% Co) + (0.06-1% Ti), the balance copper.

A further aspect of the present invention is a higher order beryllium-cobalt-copper alloy represented by the formula (0.15-0.5% Be) + (0.35-0.6% Co) + [(0.06-1% Zr) and/or (0.06-1% Ti)], the balance copper. The sum of %Zr and %Ti is generally within a range of 0.06% and 1%. This alloy is similarly characterized by improved stress relaxation resistance without loss of strength or electrical conductivity.

Generally speaking, these formulas indicate ranges of constituents which have consistently improved properties of beryllium-nickel-copper and beryllium-cobalt-copper alloys for purposes of high performance applications. Such alloys not only provide strength and conductivity comparable to conventional alloys, but also substantial improvement in stress relaxation resistance over competitive alloys such as C7025, C7026 and like heat treated copper-based alloys. The percent of each constituent, it is noted, is preferably weight based, as will be appreciated by those skilled in the art.

Illustrative compositions of lean Be-Ni-Cu arid Be-Co-Cu alloys, according to various aspects of the present invention, are shown in Table I. Heat nos. 1-5 were initially air induction melted and lab-cast as small rolling blocks. The blocks were hot rolled to about 0.300 in. thickness nominal, then cold rolled to about 0.030 in. ready-to-finish thickness. Final solution annealing was performed at about 1700°F followed by rapid quenching. The annealed strip was then cold rolled about 60% to final thickness, i.e., about 0.012 in. Final age hardening was performed at about 750°F for about 5 hrs.

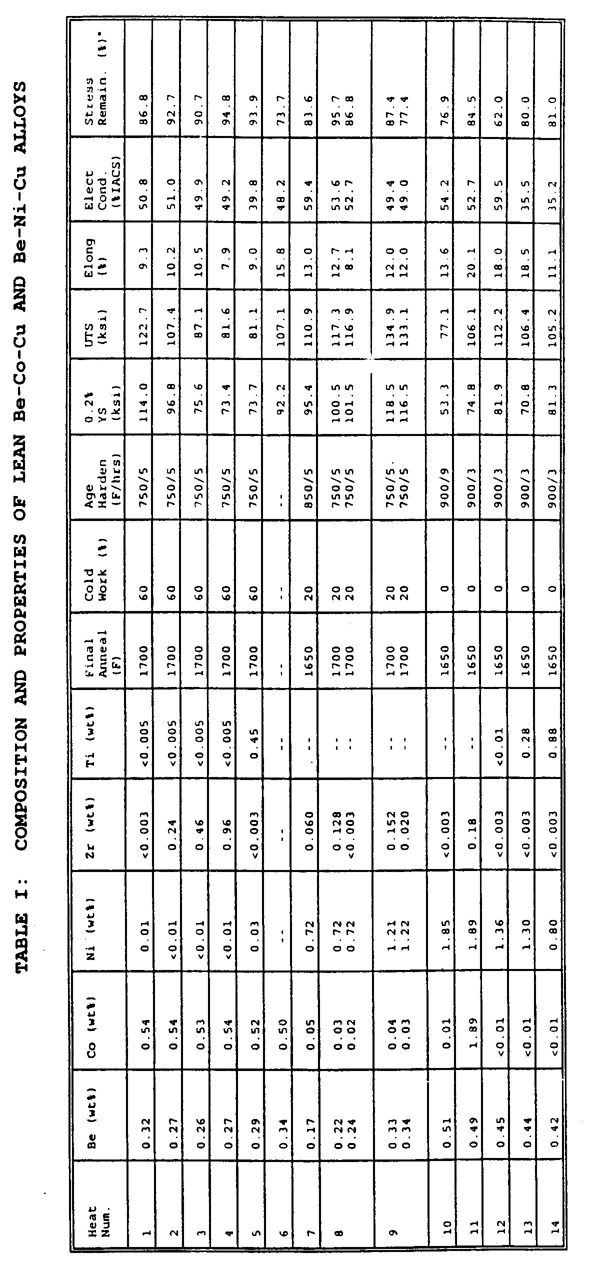

Heat nos. 8 and 9 were melted by air-induction and semi-continuously cast as billets about 7 in. thick nominal. The cast billets were then hot rolled to about 0.300 in. thickness nominal, and cold rolled to a ready-to-finish thickness of about 0.02 in. The strip of ready-to-finish thickness was solution annealed at about 1700°F, followed by a rapid quench. Next, the annealed strip was cold rolled about 20% to a final thickness of about 0.016 in., then final age hardened at about 750°F, for about 5 hrs.

The samples were evaluated for tensile properties (0.2% offset yield strength, ultimate tensile strength and elongation), electrical conductivity and stress relaxation resistance. The lean Be-Ni-Cu heats were tested for about 500 hrs. (or about 1,000 hrs. at about 175°C) with an initial stress of about 75% of the 0.2% yield strength. The Be-Co-Cu heats were tested for about 500 hrs. at 200°C with an initial stress of about 100% of the 0.2% yield strength.

Zirconium additions generally within a range of 0.25% nominal and 1% were found to increase stress relaxation resistance (at a temperature of about 175°C for about 500 hrs.) by a net of about 4% to about 8%, up to about 20%, remaining stress in lean Be-Co-Cu alloys. See, e.g., heat no. 6 versus heat nos. 2-4. The greatest improvement appeared at maximum zirconium levels of the stated range. Comparable improvements in stress relaxation resistance were found with the addition of about 0.5% Ti nominal.

At fixed solution annealing temperatures, cold working, final age temperature and time, the final yield strength of the lean Be-Co-Cu alloys decreased generally with the addition of zirconium and/or titanium. The relative loss of strength was minimal, e.g., about 15%, with the addition of 0.25% Ti nominal.

As for electrical conductivity, these zirconium additions were found to have no effect. With the addition of about 0.5% nominal to about 1%, electrical conductivity decreased only slightly, i.e., less than about net 2 %IACS.

Heat Nos. 8 and 9 further demonstrate that as little as 0.128-0.152% Zr, at levels of (0.22-0.34% Be) and (0.72-1.22% Ni), increased stress relaxation resistance by at least a net of about 8% remaining stress after about 500 hrs. at about 175^{o}C. Heat No. 7 shows that as little as 0.06% Zr provides a stress relaxation level approaching a lower limit desired for high performance electronic connectors of about 85% remaining stress after 500 hrs. at about 175^{o}C. These Zr levels improved performance of the lean Be-Ni-Cu alloys over baseline stress relaxation resistance of conventional materials, e.g., C17510. The effect of Zr additions on strength and electrical conductivity was found negligible.

As for heat nos. 10-14, Be-Ni-Cu alloys falling within a range of (0.42-0.51)% Be and (0.80-1.89)% Ni benefited from the addition of either about 0.18% Zr or up to about 0.88% Ti for purposes of stress relaxation resistance. With this relatively small addition of Zr, strength of the alloy actually improved. And this was accompanied by only a negligible loss of electrical conductivity.

Conventional lean Be-Co-Cu alloys, e.g., C17410, benefit from additions of about 0.5 wt% Ti nominal or (0.25-1 wt% Zr) in terms of improved stress relaxation resistance after 500 hrs. at 175°C. The effect of Zr additions plateaued with increasing Zr content beyond about 0.25 wt% nominal.

Be-Ni-Cu alloys generally within a range of (0.17-0.51wt% Be) and (0.71-0.89wt% Ni) also benefited from addition of as little as 0.06 wt% Zr to, preferably, (0.125-1 wt% Zr) nominal or (0.25-1 wt% Ti). The effect of Ti additions on stress relaxation behavior similarly plateaued with increasing Ti content beyond about 0.5 wt.% nominal.

Final age hardened strength was found compromised by the addition of Zr or Ti in excess of about 0.25-0.5 wt% nominal to lean Be-Co-Cu and lean Be-Ni-Cu alloys. Additions of 0.5% wt% Ti nominal or more to lean Be-Co-Cu or lean Be-Ni-Cu alloys significantly reduced electrical conductivity. Additions of (0.06-1 wt% Zr) nominal to lean Be-Co-Cu or Be-Ni-Cu alloys have only a minor effect on electrical conductivity.

Although the present invention is shown and described in connection with strip products, analagous processes may be practiced for non-strip forms, e.g., wire or rod, within the spirit and scope of the present invention.

According to one aspect of the present invention is a method of producing a lean beryllium-nickel-copper alloy with zirconium and/or titanium additions. The alloy is represented by the formula (0.15-0.5% Be) + (1.25-2.0% Ni) + [(0.06-1% Ti) and/or (0.06-1% Zr)], the balance copper, where the sum of %Zr and %Ti is generally within a range of 0.06% and 1%. Initially, a composition represented by the formula is melted, then cast into billets. The billets are hot rolled into strip intermediate annealed at about 1650°F, then cold rolled to a selected ready-to-finish thickness. Final solution annealing is performed on the cold rolled strip at a temperature of about 1650°F followed by rapid quenching. The annealed strip is cold worked generally within a range of 0% and 37% to final thickness, and final age hardened at a temperature of about 900°F for about 3 hrs.

Alternatively, a lean beryllium-cobalt-copper alloy with zirconium and/or titanium additions is produced. The alloy is represented by the formula (0.15-0.5% Be) + (0.35-0.6 Co) + [(0.06-1% Ti) and/or (0.06-1% Zr)], the balance copper, where the sum of %Zr and %Ti is generally within a range of 0.06% and 1%. The method comprises the steps of: (i) melting a composition represented by the formula, (ii) casting the melt into billets, (iii) hot rolling the billets into strip, (iv) cold rolling the strip to a selected ready to finish thickness; (v) final solution annealing the cold rolled strip at a temperature generally within a range of 1450° F and 1850°F followed by rapid quenching, (vi) cold working the annealed strip generally within a range of 50% and 95% to final thickness, and (vii) final age hardening the cold worked strip at a temperature generally within a range of 700° F and 800° F for a time generally within a range of 1 and 5 hrs.

Although the present invention is shown and described in connection with beryllium-nickel-copper and beryllium-cobalt-copper alloys, it may be adapted for improving characteristics of other precipitation hardenable materials such as aluminum-based alloys and other copper or nickel-based alloys.

Other lean beryllium-nickel-copper alloys having enhanced stress relaxation resistance, at somewhat lower nickel content, have also been achieved. Alloys of this type are described, for example, in a co-pending U.S. patent application, filed on the same date herewith by John C. Harkness and Shelley J. Wolf, entitled "Lean, High Conductivity, Relaxation-Resistant Beryllium-Nickel-Copper Alloys", the disclosure of which is hereby incorporated by reference in its entirety.

Various impurities, e.g., lead, iron, cobalt, chromium, silicon, aluminum, zinc, magnesium and silver are believed inherent in alloys of present invention, as will be appreciated by those skilled in the art.

Overall, alloys according to the present invention illustrate increased resistance to stress relaxation associated with the addition of specified amounts of zirconium and/or titanium. They also retain commercially desirable electrical conductivity.

Various modifications and alterations to the present invention may be appreciated based on a review of this disclosure. These changes and additions are intended to be within the scope and spirit of this invention as defined by the following claims.

## Claims

1. A higher order copper-base alloy containing beryllium and nickel and/or cobalt represented by the formula 0.015-0.5% Be, 1/25-2.0% Ni and/or 0.35-0.6% Co, and 0.06-1% Zr and/or Ti, balance copper, the alloy having improved stress relaxation resistance without sacrificing strength or electrical conductivity.

2. A higher order beryllium-nickel-copper alloy according to claim 1 represented by the formula 0.15-0.5% Be, 1.25-2.0% Ni and 0.06-1% Zr, the balance copper, characterised by improved stress relaxation resistance without sacrificing strength or electrical conductivity.

3. A higher order beryllium-nickel-copper alloy according to claim 1 represented by the formula 0.15-0.5% Be, 1.25-2.0% Ni and 0.06-1% Ti, the balance copper, characterized by improved stress relaxation resistance without sacrificing strength or electrical conductivity.

4. A higher order beryllium-nickel-copper alloy according to claim 1 represented by the formula 0.15-0.5% Be, 1.25-2.0% Ni, 0.06-1% Zr and 0.06-1% Ti, the balance copper, where the sum of %Zr and %Ti is generally within a range of 0.06% to 1%, characterized by improved stress relaxation resistance without sacrificing strength or electrical conductivity.

5. A higher order beryllium-cobalt-copper alloy according to claim 1 represented by the formula 0.15-0.5% Be, 0.35-0.6% Co and 0.06-1% Zr, the balance copper, characterized by improved stress relaxation resistance without sacrificing strength or electrical conductivity.

6. A higher order beryllium-cobalt-copper alloy according to claim 1 represented by the formula 0.15-0.5% Be, 0.35-0.6% Co and 0.06-1% Ti, the balance copper, characterized by improved stress relaxation resistance without sacrificing strength or electrical conductivity.

7. A higher order beryllium-cobalt-copper alloy according to claim 1 represented by the formula 0.15-0.5% Be, 0.35-0.6% Co, 0.06-1% Zr and 0.06-1% Ti, where the sum of %Zr and %Ti is generally within a range of 0.06% and 1%, the balance copper, characterised by improved stress relaxation resistance without sacrificing strength or electrical conductivity.

8. A method of producing lean beryllium-nickel-copper alloys with zirconium and/or titanium additions represented by the formula 0.15-0.5% Be, 1.25-2.0% Ni and 0.06-1% Ti and/or 0.06-1% Zr, where the sum of %Zr and %Ti is generally within a range of 0.06% and 1%, the balance copper, the method comprising the steps of:
(i) melting a composition represented by the formula,
(ii) casting the melt into billets,
(iii) hot rolling the billets into strip,
(iv) cold rolling the strip to a selected ready-to-finish thickness,
(v) final solution annealing the cold rolled strip at a temperature generally within a range of 1450°F and 1850°F, preferably 1550°F and 1700°F, followed by rapid quenching,
(vi) cold working the annealed strip to generally within a range of 0% and 95%, preferably 50% and 90%, to final thickness, and
(v) final age hardening the cold worked strip at a temperature generally within a range of 700°F and 950°F, preferably 700°F and 800°F, for a time generally within a range of 1 to 16 hours, preferably 1 and 5 hours.

9. A method according to claim 8, including the steps of
(iv) intermediate annealing the strip of step (iii) and
(v) cold rolling the annealed strip to a selected ready-to-finish thickness.

10. A method of producing a lean beryllium-cobalt-copper alloy with zirconium and/or titanium additions represented by the formula 0.15-0.5% Be, 0.35-0.6% Co and 0.06-1% Ti and/or 0.06-1% Zr, the balance copper, where the sum of %Zr and %Ti is generally within a range of 0.6% and 1%, the method comprising steps of:
(i) melting a composition represented by the formula,
(ii) casting the melt into billets,
(iii) hot rolling the billets into strip,
(iv) cold rolling the strip to a selected ready to finish thickness;
(v) final solution annealing the cold rolled strip at a temperature generally within a range of 1450°F and 1850°F followed by rapid quenching,
(vi) cold working the annealed strip generally within a range of 50% and 95% to final thickness, and
(vii) final age hardening the cold worked strip at a temperature generally within a range of 700°F and 800°F for a time generally within a range of 1 and 5 hours.

11. A method according to claim 10, including the step of
(iv) intermediate annealing the hot rolled strip of step (iii) at about 1650°F,
(v) cold rolling the strip to a selected ready-to-finish thickness,
(vi) final solution annealing the cold rolled strip at a temperature of about 1650°F followed by rapid quenching,
(vii) cold working the annealed strip generally within a range of 0% and 37% final thickness, and
(viii) final age hardening the cold worked strip at a temperature of about 900°F for about 3 hours.

12. An article of manufacture comprising a higher order beryllium-nickel-copper alloy according to any of claims 2 to 4.

13. The article set forth in claim 12 comprising an electronic connector.

14. The article set forth in claim 12 comprising a lead frame.

15. An article of manufacture comprising a higher order beryllium-cobalt-copper alloy according to any of claims 5 to 7.

16. The article set forth in claim 15 comprising an electronic connector.

17. The article set forth in claim 15 comprising a lead frame.
